# EUROPÄISCHE PATENTSCHRIFT

(11) **EP 1 536 479 B1**
(45) Veröffentlichungstag und Bekanntmachung des Hinweises auf die Patenterteilung: **01.01.2014**
(21) Anmeldenummer: 04022803.3
(22) Anmeldetag: 24.09.2004
(51) Int. Cl.: H01L 27/15, H01L 31/173

(54) **Strahlungsemittierendes und -empfangendes Halbleiterbauelement und Verfahren zu dessen Herstellung**
Light-emitting and -receiving semiconductor device and its manufacturing process
Dispositif de réception et émission de lumière et sa méthode de fabrication

(30) Priorität: 30.09.2003 DE 10345555
(43) Veröffentlichungstag der Anmeldung: 01.06.2005
(73) Patentinhaber: OSRAM Opto Semiconductors GmbH, 93055 Regensburg (DE)
(72) Erfinder: Plaine, Glenn-Yves, 93047 Regensburg (DE); Albrecht, Tony, 93077 Bad Abbach (DE); Brick, Peter, 93049 Regensburg (DE); Philippens, Marc, 93049 Regensburg (DE)
(74) Vertreter: Epping - Hermann - Fischer

(56) Entgegenhaltungen:
- EP-A- 0 532 025
- EP-A- 0 627 770
- DE-A1- 10 341 086
- US-A- 5 144 637
- US-A- 6 148 016
- PING ZHOU: "SURFACE-EMITTING LASER-BASED OPTICAL BISTABLE SWITCHING DEVICE" APPLIED PHYSICS LETTERS, AMERICAN INSTITUTE OF PHYSICS. NEW YORK, US, Bd. 59, Nr. 21, 18. November 1991 (1991-11-18), Seiten 2648-2650, XP000265174 ISSN: 0003-6951
- PING ZHOU ET AL: "CASCADABLE, LATCHING PHOTONIC SWITCH WITH HIGH OPTICAL GAIN BY THE MONOLITHIC INTEGRATION OF A VERTICAL-CAVITY SURFACE-EMITTING LASER AND A PN-PN PHOTOTHYRISTOR", IEEE PHOTONICS TECHNOLOGY LETTERS, IEEE SERVICE CENTER, PISCATAWAY, NJ, US, vol. 3, no. 11, 1 December 1991 (1991-12-01), pages 1009-1012, XP000232693, ISSN: 1041-1135, DOI: 10.1109/68.97844

## Beschreibung

Die Erfindung betrifft ein strahlungsemittierendes und -empfangendes Halbleiterbauelement nach dem Oberbegriff des Anspruchs 1 und ein Verfahren zu dessen Herstellung nach dem Oberbegriff des Anspruchs 27.

Halbleiterbauelemente der eingangs genannten Art sind beispielsweise aus der US 5,978,401 und Kosaka et al., Pixels Consisting of a Single Vertical-Cavity Laser Thyristor and a Double Vertical-Cavity Phototransistor, 1993 IEEE 1409-1411 bekannt. Dort ist der Aufbau der Halbleiterschichten für den strahlungsemittierenden und -empfangenden Teil des Halbleiterbauelements im wesentlichen gleich.

Von P. Zhou et al. wird in dem Artikel "Cascadable, Latching Photonic Switch with High Optical Gain by the Monolithic Integration of a Vertical-Cavity Surface-Emitting Laser and a pn-pn Photothyristor" (IEEE TRANSACTIONS PHOTONICS TECHNOLOGY LETTERS, Vol. 3, No. 11, November, 1991, p. 1009-1012) ein photonischer Schalter beschrieben, bei dem ein VCSEL und ein Photothyristor monolithisch integriert sind.

Bei optischen Sensorik-Anwendungen mit wechselndem Umgebungslicht oder mit unterschiedlichen Lichtquellen liegen üblicherweise Emitter und Empfänger räumlich nahe beieinander. Für solche Anwendungen ist es wünschenswert, auf engstem Raum unterschiedliche Komponenten (z. B. Optiken; Linsenfilter, Verstärker) neben dem Emitter und Empfänger zu montieren. Oft werden der Emitter, Empfänger und andere Komponenten jeweils als getrennte Bauelemente in separaten Bauformen nebeneinander aufgebaut, zueinander justiert und separat angesteuert.

Der vorliegenden Erfindung liegt die Aufgabe zugrunde, ein strahlungsemittierendes und -empfangendes, räumlich kompaktes Halbleiterbauelement der eingangs genannten Art zu schaffen, bei dem die strahlungsemittierenden und -empfangenden Komponenten möglichst gut aufeinander abgestimmt sind. Weiterhin ist es Aufgabe der vorliegenden Erfindung, ein Verfahren zur Herstellung solcher Halbleiterbauelemente mit möglichst geringen technischen Aufwand anzugeben.

Diese Aufgabe wird durch ein strahlungsemittierendes und -empfangendes Halbleiterbauelement mit den Merkmalen des Anspruchs 1 bzw. ein Herstellungsverfahren mit den Merkmalen des Anspruchs 27 gelöst. Vorteilhafte Weiterbildungen der Erfindung sind Gegenstand der Unteransprüche.

Erfindungsgemäß weist ein strahlungsemittierendes und -empfangendes Halbleiterbauelement zumindest einen ersten Halbleiterschichtaufbau und einen zweiten Halbleiterschichtaufbau auf, die voneinander beabstandet auf einem gemeinsamen Substrat integriert, bevorzugt monolithisch integriert, angeordnet sind. Der erste Halbleiterschichtaufbau enthält einen elektromagnetische Strahlung erzeugenden Bereich, der zwischen einem Stapel von p-leitenden Halbleiterschichten und einem Stapel von n-leitenden Halbleiterschichten des ersten Halbleiterschichtaufbaus angeordnet ist. Der zweite Halbleiterschichtaufbau umfaßt einen elektromagnetische Strahlung absorbierenden Bereich. Weiterhin weist der zweite Halbleiterschichtaufbau eine vorzugsweise integrierte Filterschicht auf der vom Substrat abgewandten Seite auf. Das Halbleiterbauelement empfängt Strahlung im Wellenlängenbereich zwischen λ₁ und λ₂, wobei λ₂ > λ₁ ist. Die Filterschicht wandelt die von der Filterschicht absorbierte Strahlung in Licht um, das eine Wellenlänge größer als λ₂ aufweist.

Vorteilhafterweise weist der Strahlung erzeugende Bereich eine Zusammensetzung auf, die verschieden von der des Strahlung absorbierenden Bereichs ist. Dadurch kann der Strahlung absorbierende Bereich Strahlung in einem breiteren Wellenlängenbereich absorbieren als der Wellenlängenbereich der vom Strahlung erzeugenden Bereich emittierten Strahlung. Ein breiterer Wellenlängenbereich für die Absorption hat insbesondere bei schmalbandigen Empfängern den Vorteil, dass auch schräg (d.h. nicht senkrecht) auf dem Empfänger einfallende Strahlung vom Strahlung erzeugenden Bereich detektiert werden kann.

Wenn die den Strahlung absorbierenden Bereich umgebenden Halbleiterschichten als Bragg-Spiegel ausgebildet sind, kann es passieren, dass schräg einfallende Strahlung, deren Wellenlänge innerhalb des zu detektierenden Absorptionsbereichs fällt, durch Interferenz-Effekte der Bragg-Spiegel den Strahlung absorbierenden Bereich nicht erreichen. Im Vergleich dazu absorbiert ein Strahlung absorbierender Bereich, der die gleiche Zusammensetzung wie der Strahlung erzeugende Bereich aufweist, in der Regel hauptsächlich Strahlung vom Strahlung erzeugenden Bereich, die senkrecht auf den absorbierenden Bereich auftrifft. Daher besteht die Gefahr, dass der Empfänger eines solchen Halbleiterbauelements einen erheblichen Teil der vom Emitter ausgestrahlte Strahlung nicht absorbiert. Der Empfänger und Emitter sind somit nicht optimal aufeinander abgestimmt.

Der Empfänger und Emitter sind gut aufeinander abgestimmt, wenn der Empfänger sämtliche oder zumindest einen möglichst großen Anteil der Strahlung vom Emitter unter den gegebenen Bedingungen detektieren kann.

Durch die unterschiedliche Zusammensetzung des Strahlung erzeugenden Bereichs und des Strahlung absorbierenden Bereichs entsteht ein größerer Spielraum für die Gestaltung der Empfindlichkeit des Empfängers. Der Empfänger kann genauer auf den Strahlungsbereich des Emitters abgestimmt werden. Vorteilhafterweise kann zusätzlich für ungünstige Umgebungsbedingungen, die die vom Emitter ausgestrahlte Strahlung bzw. das Einkoppeln dieser Strahlung im Empfänger (z. B. wie oben bereits mit der schräg einfallenden Strahlung beschrieben) beeinflussen, besser kompensiert werden.

In einer bevorzugten Ausführungsform ist der erste Halbleiterschichtaufbau vom zweiten Halbleiterschichtaufbau durch einen elektrisch isolierenden Bereich oder eine Ausnehmung getrennt. Dieser elektrisch isolierende Bereich bzw. die Ausnehmung erstreckt sich mindestens durch den Strahlung erzeugenden Bereich, aber vorzugsweise bis zum Substrat.

In einer weiteren Ausführungsform weist der erste Halbleiterschichtaufbau eine erste Halbleiterschichtenfolge auf, die den Strahlung erzeugenden Bereich enthält und auf dem Substrat angeordnet ist. Der zweite Halbleiterschichtaufbau weist auch diese erste Halbleiterschichtenfolge auf, aber zusätzlich eine zweite Halbleiterschichtenfolge, die den Strahlung absorbierenden Bereich enthält und auf der ersten Halbleiterschichtenfolge angeordnet ist. Die erste Halbleiterschichtenfolge ist also sowohl im ersten Halbleiterschichtaufbau als auch im zweiten Halbleiterschichtaufbau vorhanden. Die erste Halbleiterschichtenfolge im ersten Halbleiterschichtaufbau weist Halbleiterschichten auf, die im wesentlichen die gleiche Zusammensetzung und den gleichen Schichtaufbau aufweisen wie die erste Halbleiterschichtenfolge des zweiten Halbleiterschichtaufbaus. Üblicherweise ist die erste Halbleiterschichtenfolge von beiden Halbleiterschichtaufbauten im gleichen Abscheideschritt erzeugt worden.

Vorzugsweise weist der Strahlung erzeugende Bereich und/oder der Strahlung absorbierende Bereich eine Quantentopfstruktur auf.

In einer weiteren Ausführungsform sind die Halbleiterschichten des zweiten Halbleiterschichtaufbaus, die den Strahlung absorbierenden Bereich beidseitig umgeben, als Spiegelschichten, bevorzugt als Halbleiter-Spiegel ausgebildet. Die vom Substrat abgewandte Spiegelschicht ist vorzugsweise teildurchlässig und lässt die zu detektierende Strahlung weitestgehend durch. Ähnlich ist es auch vorgesehen, dass die Halbleiterschichten des ersten Halbleiterschichtaufbaus, die den Strahlung erzeugenden Bereich beidseitig umgeben, als Spiegelschichten, bevorzugt als Halbleiter-Spiegel ausgebildet sind. In beiden Fällen sind die Spiegelschichten vorteilhafterweise als Bragg-Spiegel ausgebildet und bilden weitergehend einen Resonator.

In einer bevorzugten Ausführungsform weist das erfindungsgemäße Halbleiterbauelement eine erste Kontaktschicht auf, die auf der von den Halbleiterschichten abgewandten Seite des Substrats angeordnet ist. Die erste Kontaktschicht ist bevorzugt als gemeinsamer Kontakt für den Emitter und Empfänger vorgesehen. In diesem Fall ist das Substrat bevorzugt elektrisch leitfähig.

Eine zweite Kontaktschicht ist vorzugsweise teilweise auf der vom Substrat abgewandten Oberfläche des ersten Halbleiterschichtaufbaus und der des zweiten Halbleiterschichtaufbaus angeordnet.

Zur separaten Ansteuerung der ersten und zweiten Halbleiterschichtaufbauten, ist vorzugsweise eine elektrisch leitende Schicht zwischen dem ersten Halbleiterschichtaufbau und dem zweiten Halbleiterschichtaufbau zumindest auf dem Substrat angeordnet. Diese elektrisch leitende Schicht ist dann mit der ersten Kontaktschicht elektrisch verbunden. Weiterhin bevorzugt ist, dass die elektrisch leitende Schicht mit der ersten Halbleiterschichtenfolge des zweiten Halbleiterschichtaufbaus elektrisch verbunden ist. Somit sind die Halbleiterschichten, die sonst einen strahlungserzeugenden Bereich im zweiten Halbleiterschichtaufbau bilden würden, kurzgeschlossen und daher deaktiviert.

Bei einem Halbleiterbauelement gemäß der Erfindung absorbiert die Filterschicht elektromagnetische Strahlung, deren Wellenlänge kleiner als λ₁ ist, (im folgenden kurzwellige Strahlung) und läßt elektromagnetische Strahlung durch, die eine Wellenlänge größer als λ₁ aufweist. Dadurch ist der Strahlung absorbierende Bereich kurzwelliger Strahlung nicht ausgesetzt. Im diesen Fall detektiert der Strahlung absorbierende Bereich elektromagnetische Strahlung, die eine Wellenlänge kleiner als λ₂ aufweist. Lediglich Strahlung mit einer Wellenlänge größer als λ₁ erreicht den Strahlung absorbierenden Bereich, wobei die Strahlung mit einer Wellenlänge größer als λ₂ nicht detektiert wird. Die Filterschicht funktioniert hier wie ein Kantenfilter, das die untere Grenze des zu empfangenden Wellenlängenbereichs bestimmt. Die obere Grenze des zu empfangenden Bereichs des Halbleiterbauelements ist durch den Strahlung absorbierenden Bereich bestimmt. Die Filterschicht ist vorzugsweise aus Halbleiterschichten gebildet und weist bevorzugt eine Quantentopfstruktur auf. Eine solche Filterschicht ist in der deutschen Patentanmeldung 10341086.4 näher beschrieben.

In einer bevorzugten Ausführungsform enthält das Halbleiterbauelement eine elektrisch isolierende Passivierungsschicht, die zumindest die vom Substrat abgewandte Oberfläche des ersten Halbleiterschichtaufbaus und/oder die vom Substrat abgewandte Oberfläche des zweiten Halbleiterschichtaufbaus teilweise bedeckt. Die nicht mit der Passivierungsschicht bedeckten Teile der Oberflächen sind hier mit der zweiten Kontaktschicht bedeckt.

Vorzugsweise bildet der erste Halbleiterschichtaufbau des Halbleiterbauelements eine Laserdiode, insbesondere eine VCSEL (Vertical Cavity Surface Emitting Laser), oder eine Mehrzahl von Laserdioden bzw. VCSELs.

Weiterhin bevorzugt bildet der zweite Halbleiterschichtaufbau einen Phototransistor, insbesondere einen Resonant-Cavity-Phototransistor, oder eine Mehrzahl von diesen.

In einer weiteren bevorzugten Ausführungsform bildet der zweite Halbleiterschichtaufbau eine Photodiode, insbesondere eine Resonant-Cavity-Photodiode, oder eine Mehrzahl von diesen.

Bei dem erfindungsgemäßen Herstellungsverfahren wird zunächst ein Substrat bereitgestellt und eine erste Halbleiterschichtenfolge, die einen Strahlung erzeugenden Bereich enthält, auf dem Substrat epitaktisch abgeschieden. Im gleichen Epitaxieschritt wird anschließend eine zweite Halbleiterschichtenfolge, die einen Strahlung absorbierenden Bereich enthält, auf der ersten Halbleiterschichtenfolge epitaktisch abgeschieden. Auf die Halbleiterschichtenfolge wird zusätzlich eine Filterschicht abgeschieden, die von der Filterschicht absorbierte Strahlung in Licht umwandelt, das eine Wellenlänge größer als λ₂ aufweist. Die zweite Halbleiterschichtenfolge wird dann strukturiert, um eine erste Stelle zur elektrischen Kontaktierung auf der vom Substrat abgewandten Oberfläche der ersten Halbleiterschichtenfolge und eine zweite Stelle zur elektrischen Kontaktierung auf der vom Substrat abgewandten Oberfläche der zweiten Halbleiterschichtenfolge freizulegen. Ein erster Halbleiterschichtaufbau, der die erste Halbleiterschichtenfolge aufweist und zwischen dem Substrat und der ersten Stelle zur Kontaktierung angeordnet ist, wird von einem zweiten Halbleiterschichtenaufbau, der die erste und die zweite Halbleiterschichtenfolge aufweist und zwischen dem Substrat und der zweiten Stelle zur Kontaktierung angeordnet ist, elektrisch isoliert. Schließlich wird eine erste Kontaktschicht auf die freie Oberfläche des Substrats aufgebracht und eine zweite Kontaktschicht zumindest auf die ersten und zweiten Stellen zur Kontaktierung aufgebracht.

Bei einer vorteilhaften Ausführungsform wird vor dem Aufbringen der Kontaktschichten eine Passivierungsschicht, die elektrisch isolierend ist, zumindest teilweise auf die freien von Substrat abgewandten Oberflächen der ersten und zweiten Halbleiterschichtenfolge aufgebracht, wobei die erste und zweite Stellen zur Kontaktierung dabei freigelassen werden. Die zweite Kontaktschicht kann zusätzlich teilweise auf die Passivierungsschicht aufgebracht werden.

Bei einer weiteren vorteilhaften Ausführungsform wird das elektrische Isolieren mittels Implantation oder Entfernen eines zwischen den ersten und zweiten Halbleiterschichtaufbauten liegenden Bereichs durchgeführt. Dieser Bereich kann die erste Halbleiterschichtenfolge oder die erste und zweite Halbleiterschichtenfolge umfassen und grenzt zumindest an das Substrat an. Die durch das Entfernen des Bereichs freigelegten Oberflächen des Substrats und der Halbleiterschichtenfolgen können jeweils vollständig oder teilweise mit der zweiten oder einer dritten Kontaktschicht durchgehend überzogen werden. Somit kann eine elektrische Verbindung zwischen der ersten und dieser zweiten/dritten Kontaktschicht erzeugt werden.

In einer bevorzugten Ausführungsform wird eine Stromeinschnürungsschicht in die erste Halbleiterschichtenfolge des ersten Halbleiterschichtenaufbaus zwischen dem Strahlung erzeugenden Bereich und der ersten Stelle zur Kontaktierung eingebracht. Die Stromeinschnürungsschicht dient zur Erhöhung der Stromdichte im Strahlung erzeugenden Bereich und zur Anregung der Lasertätigkeit.

In einer besonders bevorzugten Ausführungsform wird die Filterschicht während des einzigen Epitaxieschrittes zusätzlich auf die zweite Halbleiterschichtenfolge des zweiten Halbleiterschichtaufbaus epitaktisch abgeschieden. Die Filterschicht kann als Schichtenfolge ausgebildet werden.

In einer weiteren Ausführungsform wird beim Strukturieren der erste Halbleiterschichtaufbau so strukturiert, dass eine Mesastruktur gebildet wird, deren Seitenflächen in die erste Halbleiterschichtenfolge bis zu den Halbleiterschichten hineinragen, die zwischen dem Substrat und dem Strahlung erzeugenden Bereich liegen, so dass die Seitenfläche der Mesastruktur sich zumindest über den Strahlung erzeugenden Bereich hinaus erstrecken.

In einer weiteren bevorzugten Ausführungsform wird beim Strukturieren der zweite Halbleiterschichtaufbau so strukturiert, dass eine Mesastruktur gebildet wird, deren Seitenflächen in die zweite Halbleiterschichtenfolge bis zur ersten Halbleiterschichtenfolge hineinragen. In diesem Fall durchtrennen die Seitenfläche der Mesastruktur den Strahlung absorbierenden Bereich.

Weitere Merkmale, Vorteile und Zweckmäßigkeiten der Erfindung ergeben sich aus dem nachfolgend in Verbindung mit den Figuren 1 bis 5 erläuterten Ausführungsbeispielen. Es zeigen:
- Figur 1: eine schematische Schnittansicht eines ersten Ausführungsbeispiels eines erfindungsgemäßen Halbleiterbauelements,
- Figur 2: eine schematische Schnittansicht eines zweiten Ausführungsbeispiels eines erfindungsgemäßen Halbleiterbauelements,
- Figur 3: ein Diagramm der Bandabstände in den verschiedenen Schichten des Halbleiterbauelements von der Strahlungseinkopplungsfläche bis zum Substrat,
- Figur 4: ein Diagramm der Indium- und Aluminium-Konzentrationen in den verschiedenen Schichten des Halbleiterbauelements von der Strahlungseinkopplungsfläche bis zum Substrat und
- Figur 5a bis 5e: eine schematische Darstellung eines Verfahrensablaufes gemäß dem Verfahren betreffenden Ausführungsbeispiel.

Gleiche oder gleichwirkende Elemente sind in den Figuren mit demselben Bezugszeichen versehen. Zum besseren Verständnis sind insbesondere die Dicken der Schichten in den Figuren nicht maßstabsgerecht dargestellt.

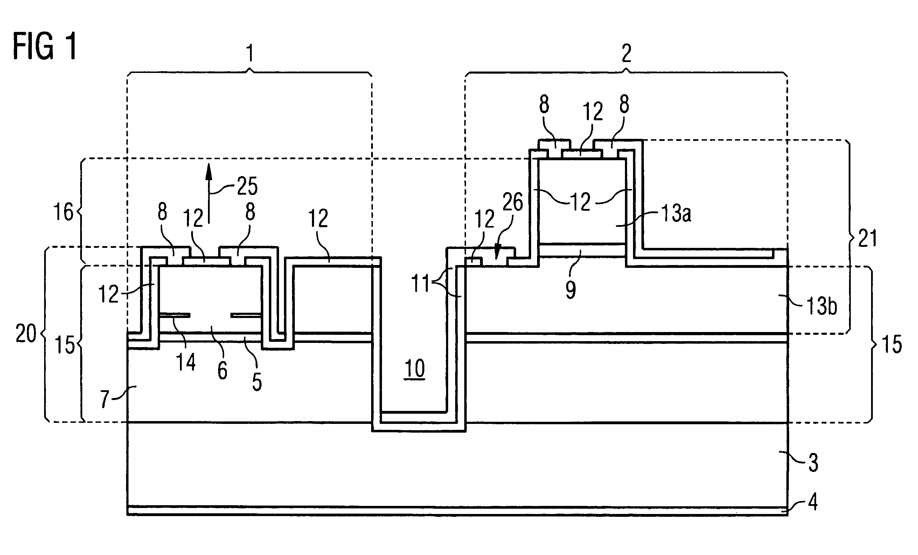

Das in Figur 1 dargestellte Halbleiterbauelement weist einen ersten Halbleiterschichtaufbau 1 und einen zweiten Halbleiterschichtaufbau 2 auf, die nebeneinander auf einem gemeinsamen Substrat 3 angeordnet sind. Beispielsweise ist das Substrat 3 ein GaAs-Substrat und vorzugsweise elektrisch leitfähig. Eine erste Kontaktschicht 4 ist auf der von den Halbleiterschichten abgewandten Seite des Substrats 3 angeordnet und enthält beispielsweise AuGe. Die erste Kontaktschicht 4 bildet in diesem Fall den n-Kontakt des Halbleiterbauelements und ist vorzugsweise ganzflächig aufgebracht.

Der erste Halbleiterschichtaufbau 1 bildet einen Emitter 20 und der zweite Halbleiterschichtaufbau 2 einen Empfänger 21. In diesem Beispiel ist der Emitter 20 als VCSEL und der Empfänger 21 als Resonant-Cavity Phototransistor ausgebildet.

Der erste Halbleiterschichtaufbau 1 weist bevorzugt eine erste Halbleiterschichtenfolge 15 auf, die einen Strahlung erzeugenden Bereich 5 enthält und auf dem Substrat 3 angeordnet ist. Der Strahlung erzeugende Bereich 5 ist zwischen p-leitenden Halbleiterschichten 6 und n-leitenden Halbleiterschichten 7 des ersten Halbleiterschichtaufbaus 1 angeordnet. Der Strahlung erzeugende Bereich 5 kann als Quantentopfstruktur ausgebildet sein. Beispielsweise umfasst dieser Strahlung erzeugende Bereich 5 drei GaAs-Quantum-Wells. Die p-leitenden 6 und n-leitenden Halbleiterschichten 7 können als Bragg-Spiegel ausgebildet sein. In diesem Fall weisen die p-leitenden 6 und n-leitenden Halbleiterschichten 7 abwechselnd Al_{0.2}Ga_{0.8}As- und Al_{0.9}Ga_{0.1}As-Schichten mit entsprechender Dotierung auf. Beispielsweise enthält der n-leitende Bragg-Spiegel 36 Perioden und der p-leitende Bragg-Spiegel 25 Perioden.

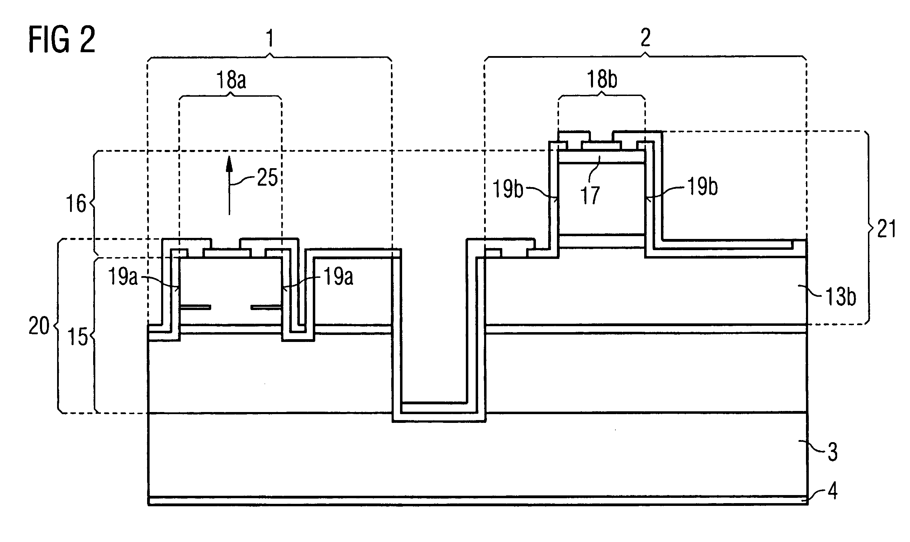

Optional weist der erste Halbleiterschichtaufbau 1 eine Mesastruktur 18a auf (siehe Figur 2), deren Seitenflächen 19a zumindest durch den Strahlung erzeugenden Bereich 5 durchschneiden. Vorzugsweise erstrecken sich die Seitenflächen 19a in die n-leitenden Halbleiterschichten 7. Zur Erhöhung der Stromdichte können die p-leitenden Halbleiterschichten 6 eine Stromeinschnürungsschicht 14 aufweisen. Die Stromeinschnürungsschicht 14 liegt vorzugsweise nahe an dem Strahlung erzeugenden Bereich 5.

Außer den Stellen, die zur elektrischen Kontaktierung und ggf. Strahlungsauskopplung vorgesehen sind, ist die vom Substrat abgewandte Oberfläche des ersten Halbleiterschichtaufbaus mit einer Passivierungsschicht 12 überzogen. Die Passivierungsschicht 12 schützt die Halbleiteroberfläche und kann zudem unerwünschte Kurzschlüsse verhindern. Oberseitig ist eine zweite Kontaktschicht 8 zur Kontaktierung der p-leitenden Halbleiterschichten 6 des ersten Halbleiterschichtaufbaus aufgebracht, die teilweise die Passivierungsschicht 12 überdeckt.

Der zweite Halbleiterschichtaufbau 2 weist ebenfalls eine erste Halbleiterschichtenfolge 15 auf dem Substrat 3 auf. Die Zusammensetzung dieser ersten Halbleiterschichtenfolge 15 des zweiten Halbleiterschichtaufbaus 2 entspricht der Zusammensetzung der ersten Halbleiterschichtenfolge 15 des ersten Halbleiterschichtaufbaus 1, wobei die p-leitenden Halbleiterschichten des zweiten Halbleiterschichtaufbaus 2 als p-leitender Bragg-Spiegel 13b des RC-Phototransistors dient. Auf dieser ersten Halbleiterschichtenfolge 15 liegt eine zweite Halbleiterschichtenfolge 16, die einen Strahlung absorbierenden Bereich 9 und einen weiteren p-leitenden Bragg-Spiegel 13a enthält. Der weitere p-leitende Bragg-Spiegel 13a weist in diesem Beispiel 10 Al_{0.2}Ga_{0.8}As/Al_{0.9}Ga_{0.1}As-Perioden auf. Der p-leitende Bragg-Spiegel 13a ist bevorzugt teildurchlässig und lässt die zu detektierende Strahlung im wesentlichen durch. Der Strahlung absorbierende Bereich 9 ist vorzugsweise als Quantentopfstruktur ausgebildet und weist beispielsweise GaAs auf.

Der erste Halbleiterschichtaufbau 1 und der zweite Halbleiterschichtaufbau 2 sind beispielsweise durch eine Ausnehmung 10 voneinander getrennt. Die Ausnehmung erstreckt sich vorzugsweise bis zum Substrat 3. Alternativ können der erste Halbleiterschichtaufbau 1 und der zweite Halbleiterschichtaufbau 2 durch einen elektrisch isolierenden Bereich getrennt sein.

Die zweite Halbleiterschichtenfolge 16 ist beispielsweise als Mesastruktur 18b ausgebildet, deren Seitenflächen 19b durch den Strahlung absorbierenden Bereich 9 durchschneiden. Vorzugsweise erstrecken sich die Seitenflächen 19b bis in den p-leitenden Bragg-Spiegel 13b. Außer einer Stelle 26, die zur elektrischen Kontaktierung mit der ersten Kontaktschicht 4 vorgesehen ist, und den Stellen zur p-Kontaktierung des Phototransistors ist die vom Substrat 3 abgewandte Oberfläche des zweiten Halbleiterschichtaufbaus 2 mit einer Passivierungsschicht 12 beschichtet. An den Stellen zur p-Kontaktierung des Transistors ist die zweite Kontaktschicht 8 angeordnet. Die zweite Kontaktschicht 8 kann auch teilweise die Passivierungsschicht 12 bedecken.

Eine elektrisch leitfähige Schicht 11 ist an der Stelle 26, die zur elektrischen Verbindung der ersten Kontaktschicht 4 mit dem p-leitenden Bragg-Spiegel 13b vorgesehen ist, aufgebracht. Diese elektrisch leitfähige Schicht 11 erstreckt sich von dieser Stelle 26 über die Ausnehmung 10 mindestens bis zum Substrat 3 und verbindet somit den p-leitenden Bragg-Spiegel 13b mit der ersten Kontaktschicht 4.

Die elektrisch leitfähige Schicht 11 kann als eine Schichtenfolge gebildet werden. Beispielsweise besteht eine solche Schichtenfolge aus der ersten und zweiten Kontaktschicht 4, 8. Sie kann aber auch eine dritte Kontaktschicht umfassen oder aus einer dritten Kontaktschicht gebildet sein.

Das oben beschriebene Halbleiterbauelement kann auch derart ausgebildet sein, dass alle p-leitenden Halbleiterschichten umgekehrt n-leitend sind und alle n-leitenden Halbleiterschichten entsprechend p-leitend sind. D.h. die Halbleiterschichten 7 des ersten Halbleiterschichtenaufbaus 1 können auch p-leitend und die Halbleiterschichten 6 entsprechend n-leitend sein. In diesem Fall ist die erste Kontaktschicht 4 folglich der p-Kontakt und die Halbleiterspiegel 13a, 13b des zweiten Halbleiterschichtaufbaus 2 entsprechend n-leitend. Die zweite Kontaktschicht 8 bildet somit den p-Kontakt.

Das in Figur 2 dargestellte Halbleiterbauelement unterscheidet sich von dem in Figur 1 dargestellten Halbleiterbauelement lediglich durch eine zusätzliche Filterschicht 17, die auf der vom Substrat 3 abgewandten Oberfläche des p-leitenden Bragg-Spiegels 13a angeordnet ist. Beispielsweise weist die Filterschicht 17 Al_{0.1}Ga_{0.9}As auf und enthält mehrere In_{0.2}Ga_{0.8}As-Quantumwells. Die Filterschicht 17 dient dazu, kurzwellige Strahlung zu absorbieren, bevor sie den Strahlung absorbierenden Bereich 9 erreicht.

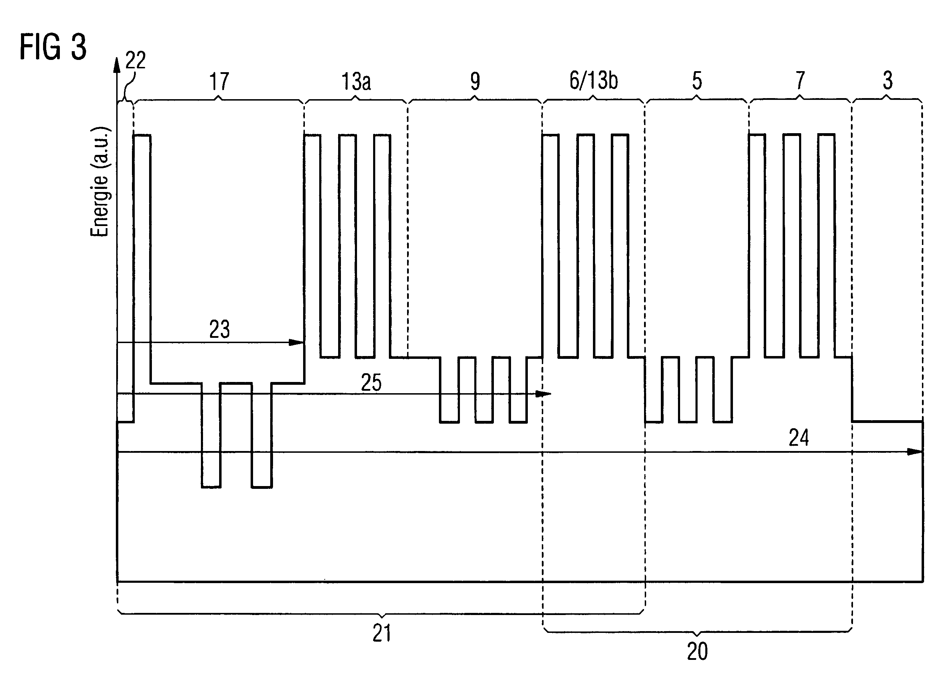

In Figur 3 sind die Bandabstände der verschiedenen Schichten des Halbleiterbauelements von der Filterschicht 17 des Empfängers 21 bis zum gemeinsamen Substrat 3 gezeigt. Bandabstände sind gegen die Schichtenabfolge, die längs der horizontalen Achse dargestellt ist, aufgetragen.

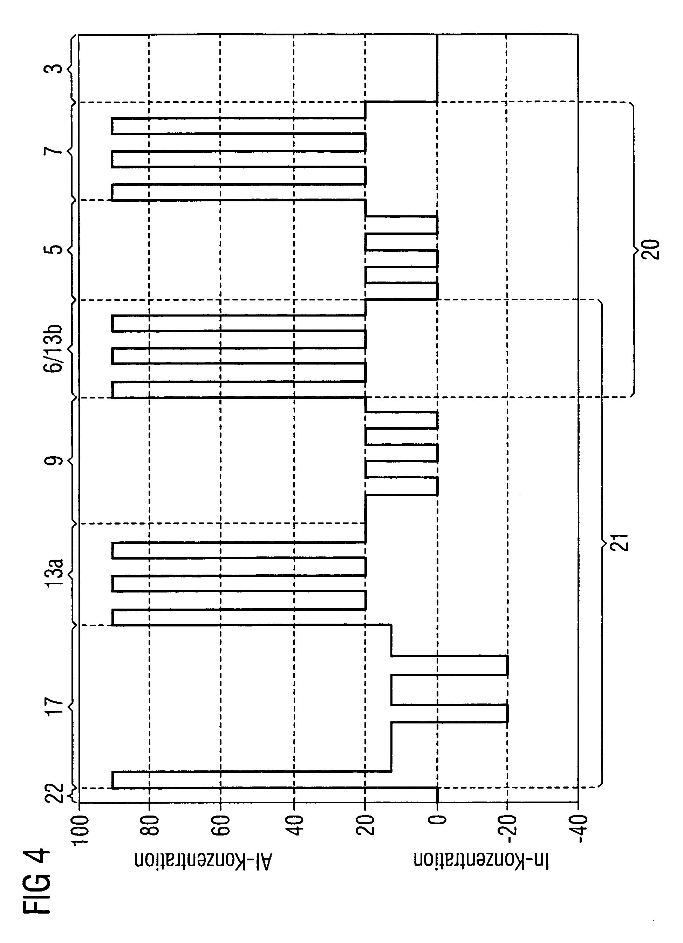

Außer einer Cap-Schicht 22, die auf der Filterschicht 17 angeordnet ist, entspricht das in Figur 3 dargestellte Halbleiterbauelement in seinem Aufbau im wesentlichen dem in Figur 2 dargestellten Ausführungsbeispiel. Die Cap-Schicht 22 ist beispielsweise aus GaAs und sehr dünn (in der Größenordnung von 10⁻⁹ m) ausgebildet. Sie dient als Schutz der Filterschicht 17 vor Oxidation. Die Filterschicht 17 enthält in der Regel relativ hohe Konzentrationen von Aluminium (siehe Figur 4) und kann leicht in einer Luft-Umgebung oxidieren. Die Cap-Schicht 22 enthält vorzugsweise kein oder kaum Aluminium-Anteile und verhindert daher die Oxidation von Aluminium an der Luft/Halbleiter-Grenzfläche. Eine solche Oxidation kann zur Störung der elektrischen Eigenschaften der Halbleiterschichten führen.

Durch die Pfeile 23 ist symbolisch kurzwelliges Licht dargestellt. Unter kurzwelligem Licht wird hier elektromagnetische Strahlung, deren Wellenlänge kleiner als die Wellenlänge der vom Emitter erzeugten Strahlung bzw. der zu absorbierenden Strahlung des Empfängers, verstanden. Umgekehrt wird unter langwelligem Licht elektromagnetische Strahlung verstanden, deren Wellenlänge größer als die Wellenlänge der vom Emitter erzeugten Strahlung bzw. der zu absorbierenden Strahlung des Empfängers. Das kurzwellige Licht 23 dringt in die Filterschicht 17 des zweiten Halbleiterschichtaufbaus ein und wird hier weitgehend absorbiert und beispielsweise durch einen Relaxationsprozess in der die in der Filterschicht 17 vorhandenen Quantentopfstruktur in langwelliges Licht umgewandelt. Quantentopfstrukturen sind in Figur 3 durch große vertikale Bandabstände in der Filterschicht 17, in dem Strahlung absorbierenden Bereich 9 und in dem Strahlung erzeugenden Bereich 5 erkennbar.

Langwelliges Licht ist durch die Pfeile 24 symbolisch dargestellt. Das langwellige Licht umfaßt das mittels der Filterschicht 17 umgewandelte Licht sowie langwelliges Umgebungslicht und wird durch die Halbleiterschichten des Halbleiterbauelements weitgehend durchgelassen.

Die zu detektierende vom Emitter erzeugte Strahlung ist durch die Pfeile 25 angedeutet. Die Strahlung 25 wird durch die Filterschicht 17 und der teildurchlässige Spiegel 13a weitgehend durchgelassen. Die Resonanzwellenlänge des mittels der Spiegel 13a, 13b gebildeten Resonators entspricht im wesentlichen der Wellenlänge der Strahlung 25.

In Figur 4 ist beispielhaft die Indium- und Aluminium-Konzentrationen der Schichten eines Halbleiterbauelements mit einem Verlauf der Bandabstände gemäß Figur 3 dargestellt. Von der Figur 4 in Verbindung mit der Figur 3 ist zu erkennen, dass eine höhere Aluminiumkonzentration einem höheren Bandabstand entspricht. Umgekehrt entspricht eine höhere Indiumkonzentration einem niedrigeren Bandabstand.

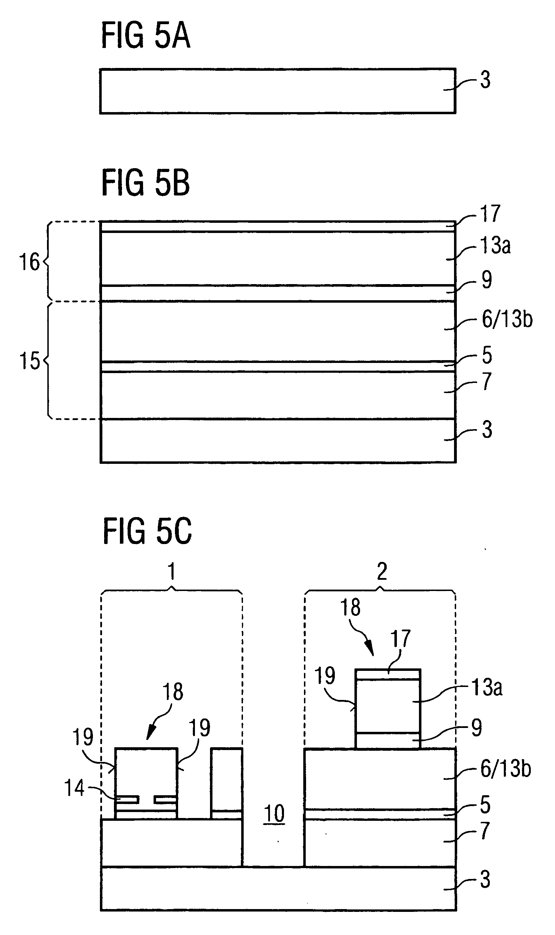

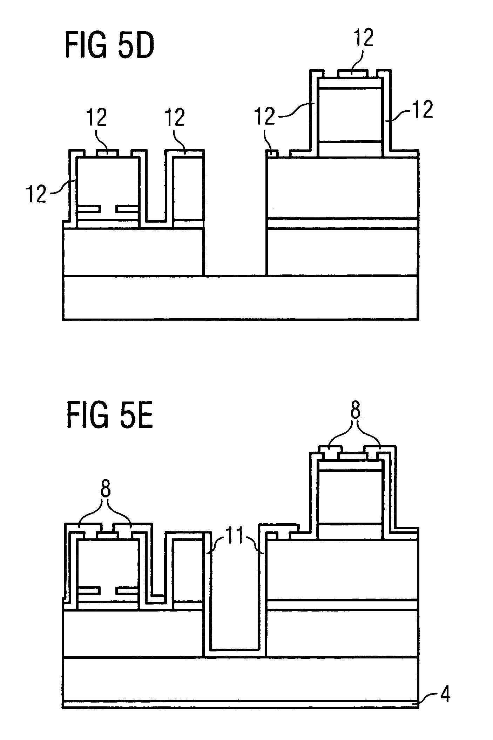

In den Figuren 5a bis 5e sind fünf Zwischenschritte eines Verfahrens zur Herstellung eines in Figur 2 dargestellten Halbleiterbauelements dargestellt.

In Figur 5a wird ein Substrat 3 bereitgestellt. Das epitaktische Abscheiden der ersten Halbleiterschichtenfolge 15 und der zweiten Halbleiterschichtenfolge 16 ist in Figur 5b dargestellt. Hier wird in einem Epitaxieschritt die p-leitenden Halbleiterschichten 7, der Strahlung erzeugende Bereich 5, die p-leitenden Halbleiterschichten 6 bzw. der p-leitende Bragg-Spiegel 13b, der Strahlung absorbierende Bereich 9, der p-leitende Bragg-Spiegel 13a und die Filterschicht 17 abgeschieden. Ein Vorteil der Ein-Schritt-Epitaxie ist, dass der Epitaxieprozess nicht unterbrochen bzw. die abgeschiedenen Halbleiterschichtenfolge nicht zwischendurch aus der Epitaxieanlage herausgenommen wird, was zu Verunreinigungen in den Halbleiterschichten führen kann. Somit kann eine hohe Qualität der Halbleiterschichten sichergestellt werden.

Nachfolgend werden die Halbleiterschichten strukturiert. Das Freilegen von zumindest einer ersten Stelle zur elektrischen Kontaktierung auf der vom Substrat 3 abgewandten Oberfläche der ersten Halbleiterschichtenfolge 15 und zumindest einer Seitenstelle zur elektrischen Kontaktierung auf der vom Substrat 3 abgewandten Oberfläche der zweiten Halbleiterschichtenfolge 16 kann mittels Photolithographie, nasschemisch oder Trockenätzen durchgeführt werden.

Optional kann die freigelegte erste Halbleiterschichtenfolge 15 und/oder die übriggebliebene zweite Halbleiterschichtenfolge 16 so strukturiert werden, dass eine Mesastruktur 18 gebildet wird. Eine solche Mesastruktur 18 weist bevorzugt Seitenflächen 19 auf, die bei der ersten Halbleiterschichtenfolge 15 zumindest bis zu den n-leitenden Halbleiterschichten 7 reichen. Bei der zweiten Halbleiterschichtenfolge 16 erstrecken sich die Seitenflächen 19 vorzugsweise zumindest bis zum Halbleiterspiegel 13b.

Eine Mesastruktur 18 bei der ersten Halbleiterschichtenfolge 15 ist besonders vorteilhaft für das Einbringen einer Stromeinschnürungsschicht 14 mittels lateraler Oxidation, weil die laterale Oxidation in die p-leitenden Halbleiterschichten durch die freigelegte Seitenfläche 19 der Mesastruktur 18 vereinfacht wird. Die Stromeinschnürungsschicht 14 kann durch Implantation, Oxidation oder einem anderen bekannten Prozess erzeugt werden.

Beispielsweise wird der erste Halbleiterschichtaufbau 1 von dem zweiten Halbleiterschichtaufbau 2 durch Ätzen einer Ausnehmung 10, die durch die Halbleiterschichten bevorzugt bis zum Substrat 3 reicht, elektrisch isoliert. Das elektrische Isolieren kann alternativ durch das Erzeugen eines elektrisch isolierenden Bereichs durchgeführt werden. Beispielsweise kann ein solcher elektrisch isolierender Bereich mittels Implantation gebildet werden.

Das elektrische Isolieren der Halbleiterschichtaufbauten kann alternativ vor dem Strukturieren der Halbleiterschichten zur Freilegung der Kontaktstellen durchgeführt werden. Der Zustand der Halbleiterschichten nach dem Strukturieren und dem elektrischen Isolieren wird in Figur 5c dargestellt.

Zunächst kann eine Passivierungsschicht 12, die elektrisch isolierend ist, zumindest teilweise auf die freien vom Substrat 3 abgewandten Oberflächen der ersten 1 und zweiten Halbleiterschichtaufbauten 2 aufgebracht werden. Dabei bleiben die erste und zweite Stelle zur Kontaktierung sowie eine dritte Kontaktstelle, die der Halbleiterspiegel 13b des zweiten Halbleiterschichtaufbaus 2 mit der ersten Kontaktschicht 4 elektrisch verbindet, frei (siehe Figur 5d). Die Passivierungsschicht 12 kann mit Hilfe von einer oder mehreren Maskenschichten und Ätzen aufgebracht werden.

Schließlich werden die Kontaktschichten 8, 4, 11 entsprechend aufgebracht. Die erste Kontaktschicht 4 wird vorzugsweise ganzflächig auf der von den Halbleiterschichten abgewandten Oberfläche des Substrats 3 aufgebracht. Die zweite Kontaktschicht 8 wird zumindest auf die erste und zweite Stellen zur Kontaktierung aufgebracht. Üblicherweise wird die zweite Kontaktschicht 8 auch teilweise über die Passivierungsschicht 12 aufgebracht. Die elektrisch leitende Schicht 11 kann während des Aufbringens der zweiten Kontaktschicht 8 gleichzeitig gebildet werden. In diesem Fall besteht die elektrisch leitende Schicht 11 aus dem gleichen Material wie die zweite Kontaktschicht 8. Die elektrisch leitende Schicht 11 bedeckt zumindest eine Fläche, die sich durchgehend von der Stelle zur Kontaktierung mit dem Halbleiterspiegel 13b bis zum Substrat 3 erstreckt. Um auch die von der Bildung der Mesastruktur 18 übriggebliebene Teile des ersten Halbleiterschichtaufbaus 1 kurzzuschließen, können die Seitenfläche der nicht zur Mesastruktur gehörenden Teile des Strahlung erzeugenden Bereich 5 und des p-leitenden Bragg-Spiegels 6 mit der elektrisch leitfähigen Schicht 11 auch überzogen werden. Bei der in Figur 1 dargestellten Gestaltung wird vorzugsweise die gesamte Fläche der Ausnehmung 10 bedeckt.

## Patentansprüche

1. Strahlungsemittierendes und -empfangendes Halbleiterbauelement mit zumindest einem ersten Halbleiterschichtaufbau (1) und einem zweiten Halbleiterschichtaufbau (2), die von einander beabstandet auf einem gemeinsamen Substrat (3) integriert angeordnet sind, wobei
- der erste Halbleiterschichtaufbau (1) einen elektromagnetische Strahlung erzeugenden Bereich (5) aufweist, der zwischen p-leitenden Halbleiterschichten (6) und n-leitenden Halbleiterschichten (7) des ersten Halbleiterschichtaufbaus (1) angeordnet ist,
- der zweite Halbleiterschichtaufbau (2) einen elektromagnetische Strahlung absorbierenden Bereich (9) aufweist,
- der Strahlung erzeugende Bereich (5) eine Zusammensetzung aufweist, die verschieden von der des Strahlung absorbierenden Bereichs (9) ist,
**dadurch gekennzeichnet , dass**
- das Halbleiterbauelement konfiguriert ist, Strahlung im Wellenlängenbereich zwischen λ₁ und λ₂ zu detektieren, wobei λ₂ > λ₁ ist,
- der zweite Halbleiterschichtaufbau (2) eine Filterschicht (17) auf der vom Substrat (3) abgewandten Seite aufweist,
- die Filterschicht (17) elektromagnetische Strahlung durchläßt, die eine Wellenlänge größer als λ₁ aufweist,
- die Filterschicht (17) elektromagnetische Strahlung absorbiert, die eine Wellenlänge kleiner als λ₁ aufweist,
- die Filterschicht (17) die von der Filterschicht (17) absorbierte Strahlung in Licht umwandelt, das eine Wellenlänge größer als λ₂ aufweist, wobei die Strahlung mit einer Wellenlänge größer als λ2 nicht detektiert wird, und- der Strahlung absorbierende Bereich (9) elektromagnetische Strahlung detektiert, die eine Wellenlänge kleiner als d₂ aufweist.

2. Halbleiterbauelement nach Anspruch 1,
bei dem der Strahlung absorbierende Bereich (9) auf die Strahlung vom Strahlung erzeugenden Bereich (5) abgestimmt ist.

3. Halbleiterbauelement nach Anspruch 1 oder 2,
bei dem der erste Halbleiterschichtaufbau (1) und der zweite Halbleiterschichtaufbau (2) nebeneinander auf dem Substrat (3) angeordnet sind.

4. Halbleiterbauelement nach einem der vorherigen Ansprüche,
bei dem der erste Halbleiterschichtaufbau (1) und der zweite Halbleiterschichtaufbau (2) voneinander durch einen elektrisch isolierenden Bereich oder eine Ausnehmung (10) beabstandet sind.

5. Halbleiterbauelement nach Anspruch 4,
bei dem die Ausnehmung (10) bis zum Substrat (3) ausgebildet ist.

6. Halbleiterbauelement nach einem der vorherigen Ansprüche, bei dem
- der erste Halbleiterschichtaufbau (1) eine erste Halbleiterschichtenfolge (15) aufweist, die den Strahlung erzeugenden Bereich (5) enthält, und
- der zweite Halbleiterschichtaufbau (2) eine erste Halbleiterschichtenfolge (15) und eine zweite Halbleiterschichtenfolge (16) aufweist, die den Strahlung absorbierenden Bereich (9) enthält, wobei
- die erste Halbleiterschichtenfolge (15) des ersten Halbleiterschichtaufbaus (1) der ersten Halbleiterschichtenfolge (15) des zweiten Halbleiterschichtaufbaus (2) entspricht und bevorzugt dieselbe Zusammensetzung aufweist,
- die ersten Halbleiterschichtenfolgen (15) jeweils auf dem Substrat (3) angeordnet sind und
- die zweite Halbleiterschichtenfolge (16) auf der erstenHalbleiterschichtenfolge (15) angeordnet ist.

7. Halbleiterbauelement nach einem der vorherigen Ansprüche,
bei dem das Substrat (3) elektrisch leitfähig ausgebildet ist.

8. Halbleiterbauelement nach Anspruch 7,
bei dem zwischen dem ersten Halbleiterschichtaufbau (1) und dem zweiten Halbleiterschichtaufbau (2) eine elektrisch leitende Schicht (11) zumindest auf dem Substrat (3) angeordnet ist, die durch das Substrat (3) mit einer ersten Kontaktschicht (4) elektrisch verbunden ist, die mit der ersten Halbleiterschichtenfolge (15) seitens des Substrats (3) elektrisch verbunden ist.

9. Halbleiterbauelement nach Anspruch 8,
bei dem die elektrisch leitende Schicht (11) als Schichtenfolge ausgebildet ist..

10. Halbleiterbauelement nach Anspruch 8 oder 9,
bei dem die elektrisch leitende Schicht (11) mit der ersten Halbleiterschichtenfolge (15) des zweiten Halbleiterschichtaufbaus (2) elektrisch verbunden ist.

11. Halbleiterbauelement nach einem der vorherigen Ansprüche,
bei dem der Strahlung erzeugende Bereich (5) und/oder der Strahlung absorbierende Bereich (9) eine Quantentopfstruktur aufweist.

12. Halbleiterbauelement nach einem der vorherigen Ansprüche,
bei dem der Strahlung absorbierende Bereich (9) zwischen zwei Spiegelschichten (13a,13b) angeordnet ist.

13. Halbleiterbauelement nach einem der vorherigen Ansprüche,
bei dem die p-leitenden Halbleiterschichten (6) und die n-leitenden Halbleiterschichten (7) des ersten Halbleiterschichtaufbaus (1) als Spiegelschichten ausgebildet sind.

14. Halbleiterbauelement nach Anspruch 12 oder 13,
bei dem die Spiegelschichten (6,7,13a,13b) als Bragg-Spiegel ausgebildet sind.

15. Halbleiterbauelement nach einem der vorherigen Ansprüche,
bei dem die erste Halbleiterschichtenfolge (15) des ersten Halbleiterschichtaufbaus (1) eine Stromeinschnürungsschicht (14) aufweist, die in den Halbleiterschichten auf der vom Substrat (3) abgewandten Seite des Strahlung erzeugenden Bereichs (5)angeordnet ist.

16. Halbleiterbauelement nach einem der vorherigen Ansprüche,
bei dem
- die erste Halbleiterschichtenfolge (15) n-leitende Halbleiterschichten (7) zwischen dem Substrat (3) und dem Strahlung erzeugenden Bereich (5) aufweist und p-leitende Halbleiterschichten (6) auf der vom Substrat (3) abgewandten Seite des Strahlung erzeugenden Bereichs (5) aufweist, und
- die zweite Halbleiterschichtenfolge (16) einen Stapel von p-leitenden Halbleiterschichten (13a) umfasst, wobei der Strahlung absorbierende Bereich (9) n-leitend ist und zwischen diesem Stapel von p-leitenden Halbleiterschichten (13a) und den p-leitenden Halbleiterschichten (6,13b) der ersten Halbleiterschichtenfolge angeordnet ist.

17. Halbleiterbauelement nach einem der Ansprüche 1 bis 14,
bei dem
- die erste Halbleiterschichtenfolge (15) p-leitende Halbleiterschichten zwischen dem Substrat (3) und dem Strahlung erzeugenden Bereich (5) aufweist und n-leitende Halbleiterschichten auf der vom Substrat (3) abgewandten Seite des Strahlung erzeugenden Bereichs (5) aufweist, und
- die zweite Halbleiterschichtenfolge (16) einen Stapel von n-leitenden Halbleiterschichten umfasst, wobei der Strahlung absorbierende Bereich (9) p-leitend ist und zwischen diesem Stapel von n-leitenden Halbleiterschichten und den n-leitenden Halbleiterschichten der ersten Halbleiterschichtenfolge (15) angeordnet ist.

18. Halbleiterbauelement nach einem der Ansprüche 1 bis 17,
bei dem die Filterschicht (17) als Halbleiterschichten ausgebildet ist.

19. Halbleiterbauelement nach einem der Ansprüche 1 bis 18,
bei dem die Filterschicht (17) zumindest eine Quantentopfstruktur aufweist.

20. Halbleiterbauelement nach einem der vorherigen Ansprüche,
bei dem zumindest die vom Substrat (3) abgewandte Oberfläche des ersten Halbleiterschichtaufbaus (1) und/oder die vom Substrat (3) abgewandte Oberfläche des zweiten Halbleiterschichtaufbaus (2) teilweise mit einer elektrisch isolierenden Passivierungsschicht (12) bedeckt ist, wobei die nicht mit der Passivierungsschicht (12) bedeckten Teile der Oberflächen mit einer zweiten Kontaktschicht (8) bedeckt sind.

21. Halbleiterbauelement nach einem der vorherigen Ansprüche,
bei dem der erste Halbleiterschichtaufbau (1) eine Laserdiode oder eine Mehrzahl von Laserdioden bildet.

22. Halbleiterbauelement nach Anspruch 21,
bei dem die Laserdiode als VCSEL ausgebildet ist.

23. Halbleiterbauelement nach einem der vorherigen Ansprüche,
bei dem der zweite Halbleiterschichtaufbau (2) einen Phototransistor oder eine Mehrzahl von Phototransistoren bildet.

24. Halbleiterbauelement nach Anspruch 23,
bei dem der Phototransistor als Resonant-Cavity-Phototransistor ausgebildet ist.

25. Halbleiterbauelement nach einem Ansprüche 1 bis 22,
bei dem der zweite Halbleiterschichtaufbau (2) eine Photodiode oder eine Mehrzahl von Photodioden bildet.

26. Halbleiterbauelement nach Anspruch 25,
bei dem bei dem die Photodiode als Resonant-Cavity-Photodiode ausgebildet ist.

27. Verfahren zur Herstellung eines integrierten Halbleiterbauelements, das einen ersten Halbleiterschichtaufbau (1) zum Emittieren von Strahlung und einen zweiten Halbleiterschichtaufbau (2) zum Empfangen von Strahlung im Wellenlängenbereich zwischen λ₁ und λ₂, wobei λ₂ > λ₁ ist, umfasst,
wobei das Verfahren folgende Verfahrensschritte umfasst:
(a) Bereitstellen eines Substrats (3),
(b) Epitaktisches Abscheiden einer ersten Halbleiterschichtenfolge (15), die einen Strahlung erzeugenden Bereich (5) enthält, auf das Substrat (3) und einer zweiten Halbleiterschichtenfolge (16), die einen Strahlung absorbierenden Bereich (9) enthält, auf die erste Halbleiterschichtenfolge (15), wobei auf die zweite Halbleiterschichtenfolge (16) eine Filterschicht (17) abgeschieden wird, die von der Filterschicht (17) absorbierte Strahlung in Licht umwandelt, das eine Wellenlänge größer als λ₂ aufweist, wobei die Strahlung mit einer Wellenlänge größer als λ₂ nicht detektiert wird, und wobei
- der Strahlung absorbierende Bereich (9) elektromagnetische Strahlung detektiert, die eine Wellenlänge kleiner als λ₂ aufweist,
- die Filterschicht (17) elektromagnetische Strahlung absorbiert, die eine Wellenlänge kleiner als λ₁ aufweist, und
- die Filterschicht (17) elektromagnetische Strahlung durchläßt, die eine Wellenlänge größer als λ₁ aufweist,
(c) Strukturieren der zweiten Halbleiterschichtenfolgen (16) oder beider Halbleiterschichtenfolgen (15,16), um zumindest eine erste Stelle zur elektrischen Kontaktierung auf der vom Substrat (3) abgewandten Oberfläche der ersten Halbleiterschichtenfolge (15) und zumindest eine zweite Stelle zur elektrischen Kontaktierung auf der vom Substrat (3) abgewandten Oberfläche der zweiten Halbleiterschichtenfolge (16) freizulegen,
(d) Elektrisches Isolieren des ersten Halbleiterschichtaufbaus (1), der die erste Halbleiterschichtenfolge (15) aufweist und zwischen dem Substrat (3) und der ersten Stelle zur Kontaktierung angeordnet ist, von dem zweiten Halbleiterschichtaufbau (2), der die erste und die zweite Halbleiterschichtenfolge (15,16) aufweist und zwischen dem Substrat (3) und der zweiten Stelle zur Kontaktierung angeordnet ist,
(e) Aufbringen einer ersten Kontaktschicht (4) auf die freie Oberfläche des Substrats (3) und einer zweiten Kontaktschicht (8) zumindest auf die ersten und zweiten Stellen zur Kontaktierung.

28. Verfahren nach Anspruch 27,
bei dem
- vor dem Verfahrensschritt (e) eine Passivierungsschicht (12), die elektrisch isolierend ist, zumindest teilweise auf die freien, vom Substrat (3) abgewandten Oberflächen des ersten (1) und zweiten Halbleiterschichtaufbaus (2) aufgebracht wird, wobei die erste und zweite Stellen zur Kontaktierung dabei freigelassen werden, und
- im Verfahrensschritt (e) die zweite Kontaktschicht (8) auf die ersten und zweiten Stellen zur Kontaktierung und zumindest teilweise auf die Passivierungsschicht (12) aufgebracht wird.

29. Verfahren nach Anspruch 27 oder 28,
bei dem das Isolieren im Verfahrensschritt (d) mittels Implantation oder Entfernen eines zwischen den ersten (1) und zweiten Halbleiterschichtaufbauten (2) liegenden Bereichs der ersten Halbleiterschichtenfolge (15) oder der ersten und zweiten Halbleiterschichtenfolgen (15,16) erfolgt, der zumindest an das Substrat (3) angrenzt.

30. Verfahren nach Anspruch 29,
bei dem die durch das Entfernen des Bereichs freigelegte Oberfläche des Substrats (3) und zumindest ein Teil der durch das Entfernen des Bereichs freigelegte Oberfläche der Halbleiterschichtenfolgen im Verfahrensschritt (e) mit der zweiten (8) oder einer dritten Kontaktschicht bedeckt wird, um eine elektrische Verbindung zwischen der ersten (4) und dieser zweiten (8)/dritten Kontaktschicht zu erzeugen.

31. Verfahren nach einem der Ansprüche 27 bis 30,
bei dem die erste (4), zweite (8) und/oder ggf. eine dritte Kontaktschicht als Schichtenfolge ausgebildet ist/sind.

32. Verfahren nach einem der Ansprüche 27 bis 31,
bei dem die erste (4), zweite (8) und ggf. eine dritte Kontaktschicht die gleiche, jeweils eine voneinander unterschiedliche Zusammensetzung oder teilweise unterschiedliche Zusammensetzungen aufweisen.

33. Verfahren nach einem der Ansprüche 27 bis 32,
bei dem vor dem Verfahrensschritt (e) und ggf. vor dem Aufbringen einer Passivierungsschicht (12) eine Stromeinschnürungsschicht (14) in die erste Halbleiterschichtenfolge (15) des ersten Halbleiterschichtaufbaus (1) zwischen dem Strahlung erzeugenden Bereich (5) und der ersten Stelle zur Kontaktierung eingebracht wird.

34. Verfahren nach einem der Ansprüche 27 bis 33,
bei dem im Verfahrensschritt (c) der zweite Halbleiterschichtaufbau (2) so strukturiert wird, dass eine Mesastruktur (18b) gebildet wird, deren Seitenflächen (19b) sich von der zweiten Halbleiterschichtenfolge (16) bis zur ersten Halbleiterschichtenfolge (15) erstrecken.

35. Verfahren nach einem der Ansprüche 27 bis 34,
bei dem im Verfahrensschritt (c) das Strukturieren mittels Ätzen erfolgt.

36. Verfahren nach einem der Ansprüche 27 bis 34,
bei dem im Verfahrensschritt (c) der erste Halbleiterschichtaufbau (1) so strukturiert wird, dass eine Mesastruktur (18a) gebildet wird, deren Seitenflächen (19a) sich von der ersten Halbleiterschichtenfolge (15) bis zu den Halbleiterschichten erstrecken, die zwischen dem Substrat (3) und dem Strahlung erzeugenden Bereich (5) liegen.

## Claims

1. Radiation-emitting and -receiving semiconductor component having at least a first semiconductor layer construction (1), and a second semiconductor layer construction (2) which are arranged spaced apart from one another in an integrated manner on a common substrate (3),
- the first semiconductor layer construction (1) having an electromagnetic-radiation-generating region (5) arranged between p-conducting semiconductor layers (6) and n-conducting semiconductor layers (7) of the first semiconductor layer construction (1),
- the second semiconductor layer construction (2) having an electromagnetic-radiation-absorbing region (9),
- the radiation-generating region (5) has a composition which is different from that of the radiation-absorbing region (9),
**characterized in that**
- the semiconductor component is configured to detect radiation in the wavelength range between λ₁ and λ₂, where λ₂ > λ₁,
- the second semiconductor layer construction (2) has a filter layer (17) on the side remote from the substrate (3),
- the filter layer (17) transmits electromagnetic radiation having a wavelength of greater than λ₁,
- the filter layer (17) absorbs electromagnetic radiation having a wavelength of less than λ₁,
- the filter layer (17) converts the radiation absorbed by the filter layer (17) into light having a wavelength of greater than λ₂, the radiation having a wavelength of greater than λ₂ not being detected, and the radiation-absorbing region (9) detects electromagnetic radiation having a wavelength of less than λ₂.

2. Semiconductor component according to Claim 1,
in which the radiation-absorbing region (9) is tuned to the radiation from the radiation-generating region (5).

3. Semiconductor component according to Claim 1 or 2,
in which the first semiconductor layer construction (1) and the second semiconductor layer construction (2) are arranged one beside the other on the substrate (3).

4. Semiconductor component according to one of the preceding claims,
in which the first semiconductor layer construction (1) and the second semiconductor layer construction (2) are spaced apart from one another by an electrically insulating region or a recess (10).

5. Semiconductor component according to Claim 4,
in which the recess (10) is formed as far as the substrate (3).

6. Semiconductor component according to one of the preceding claims,
in which
- the first semiconductor layer construction (1) has a first semiconductor layer sequence (15) containing the radiation-generating region (5), and
- the second semiconductor layer construction (2) has a first semiconductor layer sequence (15) and a second semiconductor layer sequence (16) containing the radiation-absorbing region (9),
- the first semiconductor layer sequence (15) of the first semiconductor layer construction (1) corresponding to the first semiconductor layer sequence (15) of the second semiconductor layer construction (2) and preferably having the same composition,
- the first semiconductor layer sequences (15) in each case being arranged on the substrate (3), and
- the second semiconductor layer sequence (16) being arranged on the first semiconductor layer sequence (15).

7. Semiconductor component according to one of the preceding claims,
in which the substrate (3) is formed in electrically conductive fashion.

8. Semiconductor component according to Claim 7,
in which an electrically conductive layer (11) is arranged at least on the substrate (3) between the first semiconductor layer construction (1) and the second semiconductor layer construction (2), and is electrically connected by the substrate (3) to a first contact layer (4) that is electrically connected to the first semiconductor layer sequence (15) on the part of the substrate (3).

9. Semiconductor component according to Claim 8,
in which the electrically conductive layer (11) is formed as a layer sequence.

10. Semiconductor component according to Claim 8 or 9,
in which the electrically conductive layer (11) is electrically connected to the first semiconductor layer sequence (15) of the second semiconductor layer construction (2).

11. Semiconductor component according to one of the preceding claims,
in which the radiation-generating region (5) and/or the radiation-absorbing region (9) has a quantum well structure.

12. Semiconductor component according to one of the preceding claims,
in which the radiation-absorbing region (9) is arranged between two mirror layers (13a, 13b).

13. Semiconductor component according to one of the preceding claims,
in which the p-conducting semiconductor layers (6) and the n-conducting semiconductor layers (7) of the first semiconductor layer construction (1) are formed as mirror layers.

14. Semiconductor component according to Claim 12 or 13,
in which the mirror layers (6, 7, 13a, 13b) are formed as Bragg mirrors.

15. Semiconductor component according to one of the preceding claims,
in which the first semiconductor layer sequence (15) of the first semiconductor layer construction (1) has a current constriction layer (14) arranged in the semiconductor layers on that side of the radiation-generating region (5) which is remote from the substrate (3).

16. Semiconductor component according to one of the preceding claims,
in which
- the first semiconductor layer sequence (15) has n-conducting semiconductor layers (7) between the substrate (3) and the radiation-generating region (5) and has p-conducting semiconductor layers (6) on that side of the radiation-generating region (5) which is remote from the substrate (3), and
- the second semiconductor layer sequence (16) comprises a stack of p-conducting semiconductor layers (13a), the radiation-absorbing region (9) being n-conducting and being arranged between said stack of p-conducting semiconductor layers (13a) and the p-conducting semiconductor layers (6, 13b) of the first semiconductor layer sequence.

17. Semiconductor component according to one of Claims 1 to 14,
in which
- the first semiconductor layer sequence (15) has p-conducting semiconductor layers between the substrate (3) and the radiation-generating region (5) and has n-conducting semiconductor layers on that side of the radiation-generating region (5) which is remote from the substrate (3), and
- the second semiconductor layer sequence (16) comprises a stack of n-conducting semiconductor layers, the radiation-absorbing region (9) being p-conducting and being arranged between said stack of n-conducting semiconductor layers and the n-conducting semiconductor layers of the first semiconductor layer sequence (15).

18. Semiconductor component according to one of Claims 1 to 17,
in which the filter layer (17) is formed as semiconductor layers.

19. Semiconductor component according to one of Claims 1 to 18,
in which the filter layer (17) has at least one quantum well structure.

20. Semiconductor component according to one of the preceding claims,
in which at least the surface of the first semiconductor layer construction (1) that is remote from the substrate (3) and/or the surface of the second semiconductor layer construction (2) that is remote from the substrate (3) is partially covered with an electrically insulating passivation layer (12), the parts of the surfaces that are not covered with the passivation layer (12) being covered with a second contact layer (8).

21. Semiconductor component according to one of the preceding claims,
in which the first semiconductor layer construction (1) forms a laser diode or a plurality of laser diodes.

22. Semiconductor component according to Claim 21,
in which the laser diode is formed as a VCSEL.

23. Semiconductor component according to one of the preceding claims,
in which the second semiconductor layer construction (2) forms a phototransistor or a plurality of phototransistors.

24. Semiconductor component according to Claim 23,
in which the phototransistor is formed as a resonant cavity phototransistor.

25. Semiconductor component according to one of Claims 1 to 22,
in which the second semiconductor layer construction (2) forms a photodiode or a plurality of photodiodes.

26. Semiconductor component according to Claim 25,
in which the photodiode is formed as a resonant cavity photodiode.

27. Method for producing an integrated semiconductor component comprising a first semiconductor layer construction (1) for emitting radiation and a second semiconductor layer construction (2) for receiving radiation in the wavelength range between λ₁ and λ₂, where λ₂ > λ₁,
the method comprising the following method steps:
(a) provision of a substrate (3),
(b) epitaxial deposition of a first semiconductor layer sequence (15), which contains a radiation-generating region (5), onto the substrate (3) and a second semiconductor layer sequence (16), which contains a radiation-absorbing region (9), onto the first semiconductor layer sequence (15), a filter layer (17) being deposited onto the second semiconductor layer sequence (16), which filter layer converts radiation absorbed by the filter layer (17) into light having a wavelength of greater than λ₂, the radiation having a wavelength of greater than λ₂ not being detected, and
- the radiation-absorbing region (9) detecting electromagnetic radiation having a wavelength of less than λ₂,
- the filter layer (17) absorbing electromagnetic radiation having a wavelength of less than λ₁, and
- the filter layer (17) transmitting electromagnetic radiation having a wavelength of greater than λ₁,
(c) patterning of the second semiconductor layer sequences (16) or of both semiconductor layer sequences (15, 16) in order to uncover at least one first location for electrical contact-connection on that surface of the first semiconductor layer sequence (15) which is remote from the substrate (3), and at least one second location for electrical contact-connection on that surface of the second semiconductor layer sequence (16) which is remote from the substrate (3),
(d) electrical insulation of the first semiconductor layer construction (1), which has the first semiconductor layer sequence (15) and is arranged between the substrate (3) and the first location for contact-connection, from the second semiconductor layer construction (2), which has the first and the second semiconductor layer sequence (15, 16) and is arranged between the substrate (3) and the second location for contact-connection,
(e) application of a first contact layer (4) to the free surface of the substrate (3) and a second contact layer (8) at least to the first and second locations for contact-connection.

28. Method according to Claim 27,
in which
- prior to method step (e), a passivation layer (12), which is electrically insulating, is at least partially applied to the free surfaces of the first (1) and second semiconductor layer construction (2) that are remote from the substrate (3), the first and second locations for contact-connection being left free in this case, and
- in method step (e), the second contact layer (8) is applied to the first and second locations for contact-connection and at least partially to the passivation layer (12).

29. Method according to Claim 27 or 28,
in which the insulation in method step (d) is effected by means of implantation or removal of a region - lying between the first (1) and second semiconductor layer constructions (2) - of the first semiconductor layer sequence (15) or the first and second semiconductor layer sequences (15, 16) which at least adjoins the substrate (3).

30. Method according to Claim 29,
in which the surface of the substrate (3) that is uncovered by the removal of the region and at least a part of the surface of the semiconductor layer sequences that is uncovered by the removal of the region are covered, in method step (e), with the second (8) or a third contact layer in order to produce an electrical connection between the first (4) and said second (8)/third contact layer.

31. Method according to one of Claims 27 to 30,
in which the first (4), second (8) and/or, if appropriate, a third contact layer are/is formed as a layer sequence.

32. Method according to one of Claims 27 to 31,
in which the first (4), second (8) and, if appropriate, a third contact layer have the same composition, in each case a mutually different composition or partly different compositions.

33. Method according to one of Claims 27 to 32,
in which, prior to method step (e) and, if appropriate, prior to the application of a passivation layer (12), a current constriction layer (14) is introduced into the first semiconductor layer sequence (15) of the first semiconductor layer construction (1) between the radiation-generating region (5) and the first location for contact-connection.

34. Method according to one of Claims 27 to 33,
in which, in method step (c), the second semiconductor layer construction (2) is patterned in such a way that a mesa structure (18b) is formed, the side areas (19b) of which extend from the second semiconductor layer sequence (16) as far as the first semiconductor layer sequence (15).

35. Method according to one of Claims 27 to 34,
in which, in method step (c), the patterning is effected by means of etching.

36. Method according to one of Claims 27 to 34,
in which, in method step (c), the first semiconductor layer construction (1) is patterned in such a way that a mesa structure (18a) is formed, the side areas (19a) of which extend from the first semiconductor layer sequence (15) as far as the semiconductor layers that lie between the substrate (3) and the radiation-generating region (5).

## Revendications

1. Composant à semi-conducteur émetteur et récepteur de rayonnement comprenant au moins une première structure de couches semi-conductrices (1) et une deuxième structure de couches semi-conductrices (2) qui sont disposées de manière intégrée sur un premier substrat commun (3) afin d'être espacées l'une de l'autre, dans lequel
- la première structure de couches semi-conductrices (1) comprend une zone génératrice de rayonnement électromagnétique (5) qui est disposée entre des couches semi-conductrices de type p (6) et des couches semi-conductrices de type n (7) de la première structure de couches semi-conductrices (1),
- la deuxième structure de couches semi-conductrices (2) comprend une zone (9) absorbant le rayonnement électromagnétique,
- la zone génératrice de rayonnement (5) présente une composition qui est différente de celle de la zone (9) absorbant le rayonnement,
**caractérisé en ce que**
l'élément à semi-conducteur est configuré pour détecter un rayonnement se situant dans une gamme de longueurs d'onde comprise entre λ₁ et λ₂, avec λ₂ > λ₁,
- la deuxième structure de couches semi-conductrices (2) comprend une couche filtrante (17) du côté qui est opposé au substrat (3),
- la couche filtrante (17) laisse passer un rayonnement électromagnétique dont la longueur d'onde est supérieure à λ₁,
- la couche filtrante (17) absorbe un rayonnement électromagnétique dont la longueur d'onde est inférieure à λ₁,
- la couche filtrante (17) convertit le rayonnement absorbé par la couche filtrante (17) en de la lumière dont la longueur d'onde est supérieure à λ₂, dans lequel le rayonnement de longueur d'onde supérieure à λ₂ n'est pas détecté, et la zone (9) absorbant le rayonnement détecte un rayonnement électromagnétique dont la longueur d'onde est inférieure à λ₂.

2. Composant à semi-conducteur selon la revendication 1, dans lequel la zone (9) absorbant le rayonnement est accordée au rayonnement provenant de la zone génératrice de rayonnement (5).

3. Composant à semi-conducteur selon la revendication 1 ou 2, dans lequel la première structure de couches semi-conductrices (1) et la deuxième structure de couches semi-conductrices (2) sont disposées sur le substrat (3) l'une à côté de l'autre.

4. Composant à semi-conducteur selon l'une quelconque des revendications précédentes, dans lequel la première structure de couches semi-conductrices (1) et la deuxième structure de couches semi-conductrices (2) sont séparées l'une de l'autre par une zone ou un évidement (10) électriquement isolant.

5. Composant à semi-conducteur selon la revendication 4, dans lequel l'évidemment (10) est formé jusqu'au substrat (3).

6. Composant à semi-conducteur selon l'une quelconque des revendications précédentes, dans lequel
- la première structure de couches semi-conductrices (1) comprend une première série de couches semi-conductrices (15) qui contient la zone génératrice de rayonnement (5), et
- la deuxième structure de couches semi-conductrices (2) comprend une première série de couches semi-conductrices (15) et une deuxième série de couches semi-conductrices (16) qui contiennent la zone (9) absorbant le rayonnement, dans lequel
- la première série de couches semi-conductrices (15) de la première structure de couches semi-conductrices (1) correspond à la première série de couches semi-conductrices (15) de la deuxième structure de couches semi-conductrices (2) et présente de préférence la même composition,
- les premières séries de couches semi-conductrices (15) sont respectivement disposées sur le substrat (3), et
- la deuxième série de couches semi-conductrices (16) est respectivement disposée sur la première série de couches semi-conductrices (15).

7. Composant à semi-conducteur selon l'une quelconque des revendications précédentes, dans lequel le substrat (3) est réalisé de manière à être électriquement conducteur.

8. Composant à semi-conducteur selon la revendication 7, dans lequel une couche électriquement conductrice (11) est disposée au moins sur le substrat (3) entre la première structure de couches semi-conductrices (1) et la deuxième structure de couches semi-conductrices (2), laquelle couche est électriquement connectée par l'intermédiaire du substrat (3) à une première couche de contact (4) qui est électriquement connectée à la première série de couches semi-conductrices (15) du côté du substrat (3).

9. Composant à semi-conducteur selon la revendication 8, dans lequel la couche électriquement conductrice (11) est réalisée sous la forme d'une série de couches.

10. Composant à semi-conducteur selon la revendication 8 ou 9, dans lequel la couche électriquement conductrice (11) est électriquement connectée à la première série de couches semi-conductrices (15) de la première structure de couches semi-conductrices (2).

11. Composant à semi-conducteur selon l'une quelconque des revendications précédentes, dans lequel la région génératrice de rayonnement (5) et/ou la région (9) absorbant le rayonnement comprend une structure de puits quantique.

12. Composant à semi-conducteur selon l'une quelconque des revendications précédentes, dans lequel la couche (9) absorbant le rayonnement est disposée entre deux couches réfléchissantes (13a, 13b).

13. Elément à semi-conducteur selon l'une quelconque des revendications précédentes, dans lequel les couches semi-conductrices de type p (6) et les couches semi-conductrices de type n (7) de la première structure de couches semi-conductrices (1) sont réalisées sous la forme de couches réfléchissantes.

14. Composant à semi-conducteur selon la revendication 12 ou 13, dans lequel les couches réfléchissantes (6, 7, 13a, 13b) sont réalisées sous la forme de miroirs de Bragg.

15. Composant à semi-conducteur selon l'une quelconque des revendications précédentes, dans lequel la première série de couches semi-conductrices (15) de la première structure de couches semi-conductrices (1) comprend une couche de confinement de courant (14) qui est disposée dans les couches semi-conductrices du côté de la zone génératrice de rayonnement (5) qui est opposé au substrat (3).

16. Composant à semi-conducteur selon l'une quelconque des revendications précédentes, dans lequel
- la première série de couches semi-conductrices (15) comprend des couches semi-conductrices de type n (7) entre le substrat (3) et la région génératrice de rayonnement (5) et des couches semi-conductrices de type p (6) du côté de la région génératrice de rayonnement (5) qui est opposé au substrat (3), et
- la deuxième série de couches semi-conductrices (16) comprend un empilement de couches semi-conductrices de type p (13a), dans lequel la région (9) absorbant le rayonnement est de type n et est disposée entre ledit empilement de couches semi-conductrices de type p (13a) et les couches semi-conductrices de type p (6, 13b) de la première série de couches semi-conductrices.

17. Composant à semi-conducteur selon l'une quelconque des revendications 1 à 14, dans lequel
- la première série de couches semi-conductrices (15) comprend des couches semi-conductrices de type p entre le substrat (3) et la région génératrice de rayonnement (5) et des couches semi-conductrices de type n du côté de la région génératrice de rayonnement (5) qui est opposé au substrat (3), et
- la deuxième série de couches semi-conductrices (16) comprend un empilement de couches semi-conductrices de type n, dans lequel la région (9) absorbant le rayonnement est de type p et est disposée entre ledit empilement de couches semi-conductrices de type n et les couches semi-conductrices de type n de la première série de couches semi-conductrices (15).

18. Composant à semi-conducteur selon l'une quelconque des revendications 1 à 17, dans lequel la couche filtrante (17) est réalisée sous la forme de couches semi-conductrices.

19. Composant à semi-conducteur selon l'une quelconque des revendications 1 à 18, dans lequel la couche filtrante (17) comprend au moins une structure de puits quantique.

20. Composant à semi-conducteur selon l'une quelconque des revendications précédentes, dans lequel au moins la surface de la première structure de couches semi-conductrices (1) qui est opposée au substrat (3) et/ou la surface de la deuxième structure de couches semi-conductrices (2) qui est opposée au substrat (3) est partiellement revêtue d'une couche de passivation électriquement isolante (12), dans lequel la partie non revêtue de la couche de passivation (12) de la surface est revêtue d'une deuxième couche de contact (8).

21. Composant à semi-conducteur selon l'une quelconque des revendications précédentes, dans lequel la première structure de couches semi-conductrices (1) forme une diode laser ou une pluralité de diodes laser.

22. Composant à semi-conducteur selon la revendication 21, dans lequel la diode laser est réalisée sous la forme d'un VCSEL.

23. Elément à semi-conducteur selon l'une quelconque des revendications précédentes, dans lequel la deuxième structure de couches semi-conductrices (2) forme un phototransistor ou une pluralité de phototransistors.

24. Composant à semi-conducteur selon la revendication 23, dans lequel le phototransistor est réalisé sous la forme d'un phototransistor à cavité résonante.

25. Composant à semi-conducteur selon l'une quelconque des revendications 1 à 22, dans lequel la deuxième structure de couches semi-conductrices (2) forme une photodiode ou une pluralité de photodiodes.

26. Composant à semi-conducteur selon la revendication 25, dans lequel la photodiode est réalisée sous la forme d'une photodiode à cavité résonante.

27. Procédé de fabrication d'un composant à semi-conducteur intégré qui comprend une première structure de couches semi-conductrices (1) destinée à émettre un rayonnement et une deuxième structure de couches semi-conductrices (2) destinée à recevoir un rayonnement se situant dan la gamme de longueurs d'onde comprise entre λ₁ et λ₂, avec λ₂ > λ₁,
dans lequel le procédé comprend les étapes de procédé suivantes .
(a) fournir un substrat (3),
(b) déposer par épitaxie une première série de couches semi-conductrices (15) qui contient une région génératrice de rayonnement (5), sur le substrat (3) et une deuxième série de couches semi-conductrices (16), qui contient une région (9) absorbant le rayonnement, sur la première série de couches semi-conductrices (15), dans lequel on dépose sur la deuxième série de couches semi-conductrices (16) une couche filtrante (17) qui transforme le rayonnement absorbé par la couche filtrante (17) en de la lumière dont la longueur d'onde est supérieure à λ₂, et dans lequel le rayonnement ayant une longueur d'onde supérieure à λ₂ n'est pas détecté, et dans lequel
- la région (9) absorbant le rayonnement détecte un rayonnement électromagnétique dont la longueur d'onde est inférieure à λ₂,
- la couche filtrante (17) absorbe un rayonnement électromagnétique dont la longueur d'onde est inférieure à λ₁, et
- la couche filtrante (17) laisse passer un rayonnement électromagnétique dont la longueur d'onde est supérieure à λ₁,
(c) structurer les deuxièmes séries de couches semi-conductrices (16) ou les deux séries de couches semi-conductrices (15, 16) pour libérer au moins un premier point d'établissement de contact électrique sur la surface de la première série de couches semi-conductrices (15) qui est opposée au substrat (3) et au moins un point d'établissement de contact électrique sur la surface de la deuxième série de couches semi-conductrices (16) qui est opposée au substrat (3),
(d) isoler électriquement la première structure de couches semi-conductrices (1) qui comprend la première série de couches semi-conductrices (15) et est disposée entre le substrat (3) et le premier point d'établissement de contact, de la deuxième structure de couches semi-conductrices (2) qui comprend les première et deuxième séries de couches semi-conductrices (15, 16) et est disposée entre le substrat (3) et le second point d'établissement de contact,
(e) appliquer une première couche de contact (4) sur la surface libre du substrat (3) et une deuxième couche de contact (8) au moins sur les premier et second points d'établissement de contact.

28. Procédé selon la revendication 27, dans lequel
- avant l'étape de procédé (e), une couche de passivation (12) qui est électriquement isolante est déposée au moins en partie sur les surfaces libres opposées au substrat (3) des première (1) et deuxième (2) structures de couches semi-conductrices, dans lequel les premier et second points d'établissement de contact sont ainsi libérés, et
- lors de l'étape de procédé (e), la deuxième couche de contact (8) est appliquée aux premier et second points d'établissement de contact et au moins en partie sur la couche de passivation (12).

29. Procédé selon la revendication 27 ou 28, dans lequel l'isolation effectuée lors de l'étape de procédé (d) s'effectue par implantation ou élimination d'une région située entre les première (1) et deuxième (2) structures de couches semi-conductrices de la première série de couches semi-conductrices (15) ou des première et deuxième séries de couches semi-conductrices (15, 16), qui est au moins adjacente au substrat (3).

30. Procédé selon la revendication 29, dans lequel la surface du substrat (3) libérée par élimination de la région et au moins une partie de la surface libérée par élimination de la région des séries de couches semi-conductrices lors de l'étape de procédé (e) est revêtue de la deuxième (8) ou d'une troisième couche de contact afin de générer une connexion électrique entre la première (4) et ladite deuxième (8)/troisième couche de contact.

31. Procédé selon l'une quelconque des revendications 27 à 30, dans lequel les première (4), deuxième (8) et/ou le cas échéant, troisième couches de contact est/sont réalisée(s) sous la forme d'une série de couches.

32. Procédé selon l'une quelconque des revendications 27 à 31, dans lequel les première (4), deuxième (8) et le cas échéant, troisième couches de contact comprennent des compositions identiques, des compositions respectivement différentes les unes des autres ou des compositions partiellement différentes.

33. Procédé selon l'une quelconque des revendications 27 à 32, dans lequel, avant l'étape de procédé (e) et le cas échéant, avant l'application d'une couche de passivation (12), une couche de confinement de courant (14) est introduite dans la première série de couches semi-conductrices (15) de la première structure de couches semi-conductrices (1) entre la région génératrice de rayonnement (5) et le premier point d'établissement de contact.

34. Procédé selon l'une quelconque des revendications 27 à 33, dans lequel, lors de l'étape de procédé (c), la deuxième structure de couches semi-conductrices (2) est structurée de manière à former une structure de mésa (18b) dont les surfaces latérales (19b) s'étendent de la seconde série de couches semi-conductrices (16) jusqu'à la première série de couches semi-conductrices (15).

35. Procédé selon l'une quelconque des revendications 27 à 34, dans lequel, lors de l'étape de procédé (c), la structuration s'effectue par attaque chimique.

36. Procédé selon l'une quelconque des revendications 27 à 34, dans lequel, lors de l'étape de procédé (c), la structure de couches semi-conductrices (1) est structurée de manière à former une structure de mésa (18a) dont les surfaces latérales (19a) s'étendent de la première série de couches semi-conductrices (15) jusqu'aux couches semi-conductrices qui se situent entre le substrat (3) et la région génératrice de rayonnement (5).
